# EUROPÄISCHE PATENTANMELDUNG

(11) **EP 2 529 846 A1**
(43) Veröffentlichungstag der Anmeldung: **05.12.2012**
(21) Anmeldenummer: 11004451.8
(22) Anmeldetag: 31.05.2011
(51) Int. Cl.: B06B 1/06, H01L 41/047

(54) **Ultraschallbaugruppe**

(71) Anmelder: Pepperl & Fuchs GmbH, 68307 Mannheim (DE)
(72) Erfinder: Dörr, Klaus, 68229 Mannheim (DE)
(74) Vertreter: Schiffer, Axel Martin

(57) **Zusammenfassung**

Die Erfindung betrifft eine Ultraschallbaugruppe mit einer Leiterplatte (10), an welcher mindestens ein Ultraschallwandler (20) zum Aussenden und/oder Empfangen von Ultraschallwellen, Elektronikmittel (30) zum Ansteuern des Ultraschallwandlers und/oder zum Verarbeiten von Ultraschallwellen, die von dem Ultraschallwandler nachgewiesen werden, und Befestigungsmittel (40) zum Montieren der Ultraschallbaugruppe an einem Einsatzort angeordnet sind. Dabei weist der Ultraschallwandler ein Piezoelement mit einer ersten und einer zweiten metallischen Beschichtung als Elektroden auf. Die erste metallische Beschichtung ist mindestens an einer der Leiterplatte zugewandten Seite des Piezoelements ausgebildet und die zweite metallische Beschichtung erstreckt sich von einer der Leiterplatte abgewandten Seite des Piezoelements durchgängig bis zu der der Leiterplatte zugewandten Seite. Die Ultraschallbaugruppe ist erfindungsgemäß dadurch gekennzeichnet, dass die erste und die zweite metallische Beschichtung flächig mit auf der Leiterplatte vorhandenen elektrischen Kontakten verbunden sind und dass der Ultraschallwandler flächig auf der Leiterplatte aufliegend montiert ist.
Die Erfindung betrifft außerdem ein Ultraschall-Sensorsystem.

## Beschreibung

Die vorliegende Erfindung bezieht sich auf eine Ultraschallbaugruppe nach dem Oberbegriff des Anspruchs 1.

Eine gattungsgemäße Ultraschallbaugruppe weist eine Leiterplatte auf, an welcher mindestens ein Ultraschallwandler zum Aussenden und/oder Empfangen von Ultraschallwellen, Elektronikmittel zum Ansteuern des Ultraschallwandlers und/oder zum Verarbeiten von Ultraschallwellen, die von dem Ultraschallwandler nachgewiesen werden, und Befestigungsmittel zum Montieren der Ultraschallbaugruppe an einem Einsatzort angeordnet sind. Der Ultraschallwandler weist ein Piezoelement mit einer ersten und einer zweiten metallischen Beschichtung als Elektroden auf. Die erste metallische Beschichtung ist mindestens an einer der Leiterplatte zugewandten Seite des Piezoelements ausgebildet und die zweite metallische Beschichtung erstreckt sich von einer der Leiterplatte abgewandten Seite des Piezoelements durchgängig bis zu der der Leiterplatte zugewandten Seite.

Solche Ultraschallbaugruppen werden beispielsweise in Ultraschall-Sensorsystemen zum Messen eines Objektabstands oder zum Feststellen der Anwesenheit eines Objekts eingesetzt. Insbesondere kann die Anwesenheit bedruckter oder zu bedruckender Bögen ermittelt werden. Hierbei kann zwischen einem einzelnen Bogen und einem Doppelbogen, das heißt zwei aufeinander liegenden Bögen, beispielsweise in Druckern oder Kopierern, unterschieden werden.

Herkömmliche Ultraschall-Sensorsysteme zur Objekterkennung nutzen dieselbe Ultraschallbaugruppe sowohl zum Aussenden als auch zum Empfangen von Ultraschallwellen. Nach dem Aussenden der Ultraschallwellen schwingt der Ultraschallwandler weiter. Dies verursacht eine sogenannte Totzeit, in welcher zurückkommende Ultraschallwellen nicht gemessen werden können. Die Abklingzeit der Schwingung des Ultraschallwandlers und der Leiterplatte soll deshalb bei herkömmlichen Ultraschallbaugruppen möglichst gering sein.

Dazu wird bei bekannten Ultraschallbaugruppen die Schwingung bedämpft, indem der Ultraschallwandler umschäumt in einem Wandlerbecher aufgenommen ist.

Um die Elektroden des Piezoelements mit elektrischen Kontakten auf der Leiterplatte durch die Umschäumung zu verbinden, werden bei diesen herkömmlichen Ultraschallbaugruppen Drähte verwendet.

Nachteilig ist hier der aufwändige Aufbau, der mit beträchtlichen Kosten einhergeht.

Eine weitere Bauart von Ultraschallsensoren ist aus US 2009/0189488 A1 bekannt. Hierbei werden allerdings nicht beide Elektroden des Piezoelements von derjenigen Seite des Piezoelements elektrisch kontaktiert, die der Leiterplatte des Ultraschallsensors zugewandt ist. Vielmehr wird über einen Draht eine der beiden Elektroden auf der der Leiterplatte abgewandten Seite kontaktiert. Um die Übertragung von Schwingungen zwischen dem Piezoelement und der Leiterplatte zu verhindern, ist entweder eine Umschäumung oder ein dämpfender Stützring zwischen dem Piezoelement und der Leiterplatte vorhanden. Auch dieser Ultraschallsensor ist mit einer Verdrahtung des Piezoelements sowie einer Umschäumung oder einem dämpfenden Stützring vergleichsweise aufwändig aufgebaut.

Als eine **Aufgabe** der Erfindung kann angesehen werden, eine Ultraschallbaugruppe anzugeben, welche besonders einfach aufgebaut ist.

Diese Aufgabe wird durch die Ultraschallbaugruppe mit den Merkmalen des Anspruchs 1 gelöst.

Vorteilhafte Varianten der erfindungsgemäßen Ultraschallbaugruppe sind Gegenstand der abhängigen Ansprüche und werden außerdem in der folgenden Beschreibung, insbesondere im Zusammenhang mit den Figuren, beschrieben.

Bei der Ultraschallbaugruppe der oben genannten Art ist erfindungsgemäß vorgesehen, dass die erste und die zweite metallische Beschichtung flächig mit auf der Leiterplatte vorhandenen elektrischen Kontakten verbunden sind und dass der Ultraschallwandler flächig auf der Leiterplatte aufliegend montiert ist.

Der Erfindung liegt die Erkenntnis zugrunde, dass oftmals, insbesondere bei Verwendung eines ersten Ultraschallwandlers zum Aussenden und eines zweiten Ultraschallwandlers zum Empfangen von Ultraschallwellen, eine Verschäumung zur Bedämpfung des Ultraschallwandlers nicht notwendig ist. Vorteilhafterweise können bei der Erfindung Kosten gespart werden, wenn auf den Schaum verzichtet wird.

Als ein Grundgedanke der Erfindung kann erachtet werden, dass das Piezoelement direkt auf der Leiterplatte angebracht ist. Weil zwischen dem Piezoelement und der Leiterplatte keine Verschäumung notwendig ist, kann die elektrische Kontaktierung der Elektroden des Piezoelements besonders einfach ausgeführt sein. Vorteilhafterweise sind hierzu keine Drähte notwendig. Vielmehr kann das Piezoelement, welches in der Regel eine Plättchenform hat, mit einer flachen Seite, das heißt einer der beiden flächigen Seiten der Plättchenform, auf der Leiterplatte aufliegend angebracht sein.

Ein Kerngedanke der Erfindung kann darin gesehen werden, dass der Ultraschallwandler von der Leiterplatte nur durch ein elektrisch leitfähiges Verbindungsmittel und eventuell Luft getrennt ist. Insbesondere ist kein zusätzliches Dämpfungsmittel zwischen dem Piezoelement und der Leiterplatte vorhanden. Hierdurch wird vorteilhafterweise eine besonders einfache Herstellung ermöglicht.

Bei einer bevorzugten Ausführung der erfindungsgemäßen Ultraschallbaugruppe ist der Ultraschallwandler mit einem elektrisch leitfähigen Kleber, wie zum Beispiel Silberleitkleber, auf die Leiterplatte geklebt und so mit den elektrischen Kontakten der Leiterplatte verbunden. Durch den elektrisch leitfähigen Kleber wird sowohl das Montieren des Ultraschallwandlers auf die Leiterplatte als auch das Bereitstellen einer elektrischen Verbindung zwischen den Elektroden des Piezoelements und den elektrischen Kontakten der Leiterplatte bewerkstelligt. Gegenüber einer Verwendung von Drähten zur elektrischen Verbindung und separaten Befestigungsmitteln kann durch den elektrisch leitfähigen Kleber eine besonders kostengünstige Montage des Ultraschallwandlers erreicht werden.

Alternativ oder zusätzlich zu der Verbindung über den leitfähigen Kleber kann der Ultraschallwandler auf die Leiterplatte gelötet und so mit den elektrischen Kontakten der Leiterplatte verbunden sein.

Zum Vermeiden einer elektrischen Brücke zwischen den Kontakten der Leiterplatte durch das Lot oder durch den elektrisch leitfähigen Kleber ist bevorzugt in der Leiterplatte eine Nut geformt und die Lötverbindung und/oder der elektrisch leitfähige Kleber ist beidseitig der Nut vorgesehen. Durch die Nut kann auch bei einem unpräzisen Löten oder Auftragen des Klebers ein unbeabsichtigter elektrischer Kurzschluss vermieden werden.

Bei einer besonders bevorzugten Variante ist die Nut als Durchbruch ausgebildet. Zudem ist durch die erste und zweite metallische Beschichtung auf der der Leiterplatte zugewandten Seite des Piezoelements eine Lücke ohne metallische Beschichtung gebildet und das Piezoelement ist so ausgerichtet, dass die Lücke mit dem Durchbruch fluchtet. Indem die Lücke ohne metallische Beschichtung mit dem Durchbruch fluchtet, kann auch an den metallischen Beschichtungen ein unbeabsichtigter elektrischer Kontakt durch den Kleber oder die Lötverbindung vermieden werden. Die Ausgestaltung der Nut als Durchbruch erlaubt vorteilhafterweise eine einfache Überprüfung der Orientierung des Piezoelements. Hierzu kann beispielsweise ein optischer Sensor durch den Durchbruch ein Bild von dem Piezoelement oder zumindest eine von dem Piezoelement zurückgeworfene Lichtintensität messen und so zwischen den metallischen Beschichtungen und der Lücke unterscheiden.

Eine weitere bevorzugte Ausführungsform der erfindungsgemäßen Ultraschallbaugruppe ist dadurch gekennzeichnet, dass der Ultraschallwandler ungedämpft gelagert ist. Der Ultraschallwandler kann also zum weitestgehend ungedämpften Schwingen schaumlos gelagert sein. Insbesondere wenn die erfindungsgemäße Ultraschallbaugruppe entweder zum Aussenden oder zum Empfangen von Ultraschallwellen eingerichtet ist, kann zur Kostenreduzierung ohne Weiteres auf eine Dämpfung verzichtet werden.

Schwingungen, die vom Ultraschallwandler auf die Leiterplatte übertragen werden, können gemäß einer Ausgestaltung der Erfindung in ihrer Ausbreitung gehemmt werden. Dazu kann zum Reduzieren der Übertragung von mechanischen Schwingungen auf die Leiterplatte die erste metallische Beschichtung des Ultraschallwandlers an mehreren voneinander beabstandeten Kontaktstellen mit der Leiterplatte verbunden sein. Zwischen den Kontaktstellen können somit Hohlräume gebildet sein, an welchen der Ultraschallwandler nicht mechanisch an die Leiterplatte gekoppelt ist und daher im Wesentlichen frei schwingen kann. Insbesondere wenn mindestens drei voneinander beabstandete Kontaktstellen vorhanden sind, kann bei den in Ultraschallwandlern typischerweise angeregten Schwingungsmoden erreicht werden, dass die Kontaktstellen an Schwingungsknoten angeordnet sind, an welchen nur eine sehr geringe Übertragung der Schwingungsenergie erfolgt.

Es ist bevorzugt, dass der Ultraschallwandler eine Auskoppelschicht zum gerichteten Aussenden von Ultraschallwellen aufweist. Hierdurch kann eine Hauptschwingungsmode des Ultraschallwandlers, durch welche Ultraschallwellen im Wesentlichen senkrecht zur Oberfläche der Auskoppelschicht ausgesendet werden, verstärkt oder zumindest weitestgehend ungedämpft ausgekoppelt werden. Schwingungsmoden, die zu sogenannten Nebenkeulen in ungewünschte Aussenderichtungen führen, werden hingegen vorteilhafterweise durch die Auskoppelschicht unterdrückt.

Die Auskoppelschicht kann auch als Kopplungsschicht bezeichnet werden. Wird die Ultraschallgruppe zum Empfangen von Ultraschallwellen verwendet, kann die Kopplungsschicht dem Leiten der Ultraschallwellen zu dem Piezoelement dienen. Bei einer bevorzugten Ausführung ist die Kopplungsschicht mit Silikon aufgebaut.

Die vorliegende Erfindung betrifft außerdem ein Ultraschall-Sensorsystem. Bei diesem sind eine erste und eine zweite erfindungsgemäße Ultraschallbaugruppe vorhanden, wobei die erste Ultraschallbaugruppe als Ultraschallsender und die zweite Ultraschallbaugruppe als Ultraschallempfänger gebildet ist. Zum Aufspannen eines Überwachungsbereichs sind der Ultraschallsender und der Ultraschallempfänger aufeinander ausgerichtet. Weil hier der Ultraschallsender nicht zum Empfangen von ausgesandten Ultraschallwellen verwendet wird, ist ein Nachschwingen des Ultraschallsenders nach dem Aussenden von Ultraschallwellen unbedenklich.

Bei einer vorteilhaften Alternative des erfindungsgemäßen Ultraschall-Sensorsystems ist vorgesehen, dass die erste und die zweite Ultraschallbaugruppe über eine gabelartige Verbindung miteinander verbunden sind, dass Mittel zur Schwingungsentkopplung zwischen der ersten und der zweiten Ultraschallbaugruppe vorhanden sind und dass ein gemeinsames Befestigungsmittel zum Anbringen des Ultraschall-Sensorsystems an einem Einsatzort vorhanden ist. Durch die gabelartige Verbindung ist vorteilhafterweise ein Nachjustieren der Ausrichtung der beiden Ultraschallbaugruppen aufeinander überflüssig. Das gemeinsame Befestigungsmittel erleichtert die Montage des Ultraschall-Sensorsystems gegenüber dem Fall getrennt voneinander anzubringender Ultraschallsender und -empfänger. Vorteilhafterweise verhindern die Mittel zur Schwingungsentkopplung weitestgehend, dass Schwingungen der Leiterplatte der ersten Ultraschallbaugruppe auf die Leiterplatte der zweiten Ultraschallbaugruppe übertragen werden, und umgekehrt.

Bei einer bevorzugten Variante der Erfindung sind die Mittel zur Schwingungsentkopplung durch einen flexiblen Abschnitt gebildet, insbesondere durch einen flexiblen Bereich der Leiterplatte der ersten Ultraschallbaugruppe oder der Leiterplatte der zweiten Ultraschallbaugruppe. Dies kann beispielsweise durch eine flexible Leiterplatte, wie eine Starrflex-Leiterplatte, erreicht werden.

Die erfindungsgemäße Ultraschallbaugruppe und das erfindungsgemäße Ultraschall-Sensorsystem sind beispielsweise in Lese- und/oder Schreibgeräten mit einer Zuführeinrichtung für zu lesende und/oder zu beschreibende Objekte zu einem Lese- und/oder Schreibkopf einsetzbar. Bei diesen Geräten kann es sich beispielsweise um Kopierer, Scanner, Bankautomaten oder Fahrkartenautomaten handeln. Die zu lesenden oder zu beschreibenden Objekte können dementsprechend beispielsweise aus Papier, Pappe, Plastik oder Metall gebildet sein. Die Elektronikmittel der erfindungsgemäßen Ultraschallbaugruppe können dann dazu eingerichtet sein, zu erkennen, ob mit der Zuführeinrichtung ein einzelnes Objekt oder eine andere Anzahl von Objekten zugeführt wird.

Weitere Vorteile und Merkmale der Erfindung werden nachstehend mit Bezug auf die beigefügten schematischen Figuren beschrieben. Hierin zeigen:
- Fig. 1: eine schematische Darstellung eines Piezoelements einer erfindungs-gemäßen Ultraschallbaugruppe;
- Fig. 2: eine schematische Seitenansicht einer erfindungsgemäßen Ultraschall-baugruppe;
- Fig. 3: eine schematische Frontansicht eines ersten Ausführungsbeispiels ei-ner erfindungsgemäßen Ultraschallbaugruppe und
- Fig. 4: eine schematische Frontansicht eines zweiten Ausführungsbeispiels einer erfindungsgemäßen Ultraschallbaugruppe.

Äquivalente Komponenten sind in allen Figuren mit denselben Bezugszeichen gekennzeichnet.

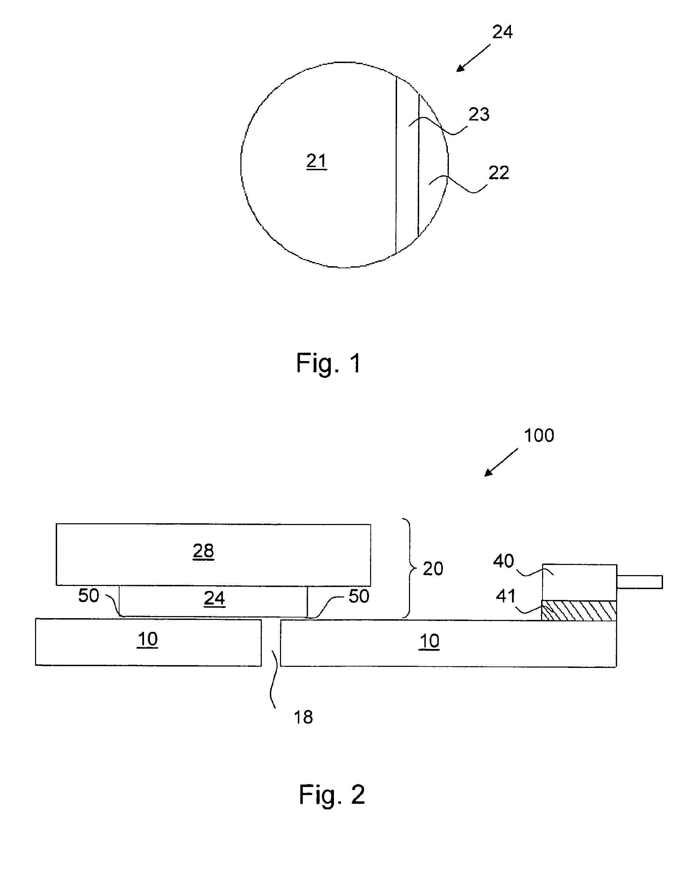

Fig. 1 ist eine schematische Darstellung eines Piezoelements 24 eines Ultraschallwandlers einer erfindungsgemäßen Ultraschallbaugruppe. Dargestellt ist die einer Leiterplatte der Ultraschallbaugruppe zugewandten Seite des Piezoelements 24. Beide Elektroden des Piezoelements 24 sind zumindest teilweise auf dieser Seite angeordnet. Dadurch ist es möglich, dass eine elektrische Verbindung zu Kontakten der Leiterplatte ausschließlich auf der der Leiterplatte zugewandten Seite des Piezoelements 24 erfolgen kann.

Als erste Elektrode ist eine erste metallische Beschichtung 21 vorhanden. Bevorzugt erstreckt sich diese über den größten Teil der der Leiterplatte zugewandten Seite des Piezoelements 24, beispielsweise über mindestens 50% oder mindestens 60%. Im dargestellten Ausführungsbeispiel ist die erste metallische Beschichtung 21 ausschließlich auf der der Leiterplatte zugewandten Seite angeordnet.

Als zweite Elektrode ist eine zweite metallische Beschichtung 22 vorhanden, welche ebenfalls flächig einen Bereich der der Leiterplatte zugewandten Seite des Piezoelements 24 überzieht, beispielsweise einen Bereich von mindestens 5%, 10% oder 20%. Die zweite metallische Beschichtung 22 erstreckt sich durchgängig bis auf die gegenüberliegende Seite des Piezoelements 24. Diese gegenüberliegende Seite kann weitestgehend oder vollständig von der zweiten metallischen Beschichtung 22 bedeckt sein.

Getrennt werden die erste und die zweite metallische Beschichtung 21, 22 auf der der Leiterplatte zugewandten Seite durch eine Lücke 23 ohne metallische Beschichtung.

In Fig. 2 ist eine Seitenansicht eines ersten Ausführungsbeispiels einer erfindungsgemäßen Ultraschallbaugruppe 100 dargestellt. Die Ultraschallbaugruppe 100 weist eine Leiterplatte 10 auf, auf welcher ein Ultraschallwandler 20 und Befestigungsmittel 40 montiert sind.

Mit den Befestigungsmitteln 40 kann die Ultraschallbaugruppe an einem Einsatzort angebracht werden. Im dargestellten Beispiel handelt es sich bei dem Befestigungsmittel 40 um einen Stecker. Alternativ kann aber auch eine Buchse oder jedes andere geeignete mechanische Befestigungsmittel vorgesehen sein. Das Befestigungsmittel 40 ist über eine Verbindung 41 an die Leiterplatte 10 angebracht. Bei der abgebildeten Ausführungsform handelt es sich hierbei um einen Kleber. Bevorzugt kann durch die Verbindung 41 eine Schwingungsdämpfung erreicht werden.

Der Ultraschallwandler 20 kann als Ultraschallsender und/oder -empfänger eingesetzt werden. Er weist ein Piezoelement 24 und eine Auskoppelschicht 28 auf.

Zur elektrischen Kontaktierung des Piezoelements 24 weist die Leiterplatte 10 hier nicht dargestellte elektrische Kontakte auf.

Das Piezoelement 24 ist flächig auf die Leiterplatte 10 montiert. Im dargestellten Fall liegt das Piezoelement 24 im Wesentlichen vollständig mit seiner der Leiterplatte zugewandten Seite auf der Leiterplatte auf. Hierbei kann das Piezoelement 24 allein durch eine elektrisch leitfähige Verbindung 50 von der Leiterplatte 10 getrennt sein. Bei dieser Verbindung 50 kann es sich insbesondere um einen elektrisch leitfähigen Kleber 50 oder eine Lötverbindung 50 handeln. Vorteilhafterweise wird über die Verbindung 50 sowohl eine Montage des Ultraschallwandlers 20 auf der Leiterplatte 10 als auch eine elektrische Kontaktierung der Elektroden des Piezoelements 24 erreicht.

Bevorzugt werden die Lötverbindung 50 oder der elektrisch leitfähige Kleber 50 auf die Leiterplatte 10 aufgebracht.

Es soll vermieden werden, dass durch den Kleber 50 oder die Lötverbindung 50 ein elektrischer Kurzschluss zwischen den Kontakten der Leiterplatte 10 entsteht. Deshalb weist die Leiterplatte 10 eine Nut 18 auf. Durch diese Nut wird ein Luftspalt zwischen den elektrischen Kontakten der Leiterplatte bereitgestellt. Vorteilhafterweise kann somit das Lot oder der Kleber 50 in einfacher Weise auf die elektrischen Kontakte der Leiterplatte 10 aufgebracht werden, ohne dass die Gefahr einer leitfähigen Brücke über die Nut 18 hinweg besteht.

In der dargestellten Ausführungsvariante ist die Nut 18 als Durchbruch ausgebildet. Durch den Durchbruch 18 kann, beispielsweise mit optischen Mitteln, überprüft werden, ob der Ultraschallwandler 20 in der richtigen Orientierung bezüglich des Durchbruchs 18 auf die Leiterplatte 10 aufgesetzt ist. In der richtigen Orientierung fluchtet der Durchbruch 18 mit der Lücke 23 ohne metallische Beschichtung des Piezoelements 24. Dadurch kann ein Kurzschluss oder eine ungewünschte elektrische Verbindung vermieden werden. Findet die Überprüfung der Orientierung des Ultraschallwandlers bereits während des Zusammenbaus der Ultraschallbaugruppe 100 statt, so kann eine falsche Orientierung eventuell noch korrigiert werden, bevor der Kleber 50 ausgehärtet ist. Die Breite der Nut 18 gleicht vorzugsweise der Breite der Lücke ohne metallische Beschichtung des Piezoelements.

Über die Kopplungsschicht 28 werden vom Piezoelement 24 erzeugte Ultraschallwellen in Richtung eines Überwachungsbereichs ausgekoppelt, beziehungsweise aus dem Überwachungsbereich kommende Ultraschallwellen werden zu dem Piezoelement 24 weitergeleitet. Dabei beeinflusst die Kopplungsschicht 28 die Aussenderichtung von Ultraschallwellen so, dass diese im Wesentlichen senkrecht zu einer Oberfläche des Piezoelements 24 steht, das heißt im Wesentlichen auch senkrecht zu der der Leiterplatte 10 zugewandten Seite des Piezoelements 24. Diese Aussenderichtung entspricht einer Hauptkeule von Ultraschallwellen. Die Ausbreitung von Nebenkeulen, das heißt Ultraschallwellen mit einer Ausbreitungsrichtung quer zur Hauptkeule, wird gehemmt, indem die Kopplungsschicht 28 die für die Nebenkeulen verantwortlichen Schwingungsmoden im Piezoelement 24 unterdrückt.

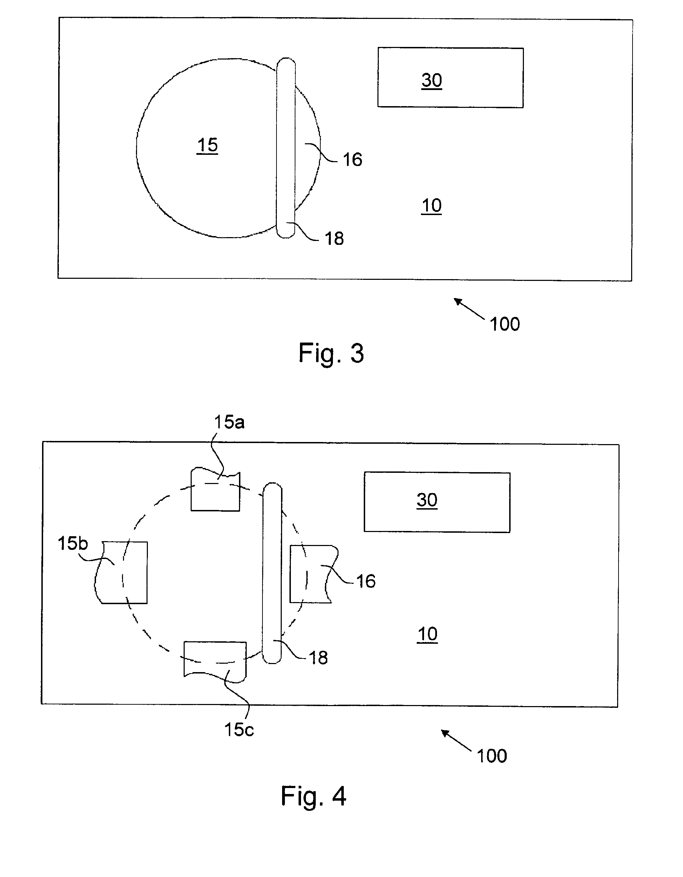

Fig. 3 zeigt eine Frontalansicht des ersten Ausführungsbeispiels einer erfindungsgemäßen Ultraschallbaugruppe 100. Hierbei sind auf der Leiterplatte 10 angeordnete Elektronikmittel 30 dargestellt. Diese sind dazu eingerichtet, dass der Ultraschallwandler als Ultraschallsender und/oder -empfänger verwendet werden kann. Dargestellt sind außerdem die elektrischen Kontakte 15, 16 der Leiterplatte 10 zum Kontaktieren der Elektroden des Piezoelements. Vorzugsweise sind die elektrischen Kontakte 15, 16 flächig ausgebildet. Im Gegensatz zu elektrischen Verbindungen über Drähte wird bevorzugt die Fläche der elektrischen Kontakte 15, 16 vollständig von dem Kleber oder dem Lot bedeckt. Diese Breite des Klebers oder des Lots ist über die gesamte Verbindungsstrecke zwischen der Leiterplatte und dem Ultraschallwandler im Wesentlichen konstant.

Ein zweites Ausführungsbeispiel einer erfindungsgemäßen Ultraschallbaugruppe 100 ist in Fig. 4 dargestellt. Dieses Ausführungsbeispiel unterscheidet sich von dem ersten Ausführungsbeispiel durch die Ausgestaltung der elektrischen Kontakte 15, 16 der Leiterplatte 10.

Bei der in Fig. 4 gezeigten Variante sind die Flächen der elektrischen Kontakte 15, 16 jeweils kleiner als die Flächen der ersten und zweiten metallischen Beschichtung 21, 22 auf der der Leiterplatte zugewandten Seite des Piezoelements. Zudem ist der elektrische Kontakt 15 zur Kontaktierung der ersten metallischen Beschichtung 21 durch mehrere voneinander beabstandete elektrische Kontakte ausgeführt. Im dargestellten Fall sind dies drei elektrische Kontakte 15a, 15b, 15c, welche auch als Klebeflächen 15a, 15b, 15c bezeichnet werden können. Diese sind so auf der Leiterplatte 10 angeordnet, dass sie die erste metallische Beschichtung 21 des Piezoelements an Randbereichen kontaktieren. Vorteilhafterweise kann hierdurch eine Schwingungsentkopplung zwischen dem Ultraschallwandler 20 und der Leiterplatte 10 erreicht werden.

Insbesondere wenn die elektrischen Kontakte 15a, 15b, 15c, 16 von der Leiterplatte 10 hervorstehen, wird bei der zusammengebauten Ultraschallgruppe 100 ein Hohlraum zwischen dem Ultraschallwandler 20 und der Leiterplatte 10 geschaffen. Dieser Hohlraum grenzt im Wesentlichen an einen zentralen Bereich des Ultraschallwandlers 20 an. Somit kann der Ultraschallwandler 20 im Wesentlichen frei schwingen und eine Übertragung der Schwingungen auf die Leiterplatte 10 findet nur in sehr geringem Umfang statt. Dies wird auch durch die beabstandete Anordnung der elektrischen Kontakte 15a, 15b, 15c zur Kontaktierung der ersten metallischen Beschichtung 21 unterstützt.

Bevorzugt wird ein Ultraschall-Sensorsystem mit zwei erfindungsgemäßen Ultraschallbaugruppen eingesetzt. Hierbei ist eine Ultraschallbaugruppe zum Aussenden von Ultraschallwellen und die andere Ultraschallbaugruppe zum Nachweisen von Ultraschallwellen eingerichtet. Zwischen den beiden Ultraschallbaugruppen wird dadurch ein Überwachungsbereich erzeugt. Anhand der Dämpfung der vom Ultraschallempfänger nachgewiesenen Ultraschallwellen kann zuverlässig die Anzahl, beispielsweise von Papierbögen, im Überwachungsbereich ermittelt werden.

Vorteilhafterweise ist bei der erfindungsgemäßen Ultraschallbaugruppe kein Dämpfungsmittel, insbesondere kein Dämpfungsschaum, um den Ultraschallwandler 20 vorhanden. Dadurch ist ein besonders einfacher und kostengünstiger Aufbau möglich, bei dem kein Wandlerbecher nötig ist.

Ein besonders effizienter Herstellungsablauf wird dadurch ermöglicht, dass die metallischen Beschichtungen des Ultraschallwandlers flächig auf der Leiterplatte aufliegen.

## Patentansprüche

1. Ultraschallbaugruppe
mit einer Leiterplatte (10), an welcher mindestens
- ein Ultraschallwandler (20) zum Aussenden und/oder Empfangen von Ultraschallwellen,
- Elektronikmittel (30) zum Ansteuern des Ultraschallwandlers (20) und/oder zum Verarbeiten von Ultraschallwellen, die von dem Ultraschallwandler (20) nachgewiesen werden, und
- Befestigungsmittel (40) zum Montieren der Ultraschallbaugruppe (100) an einem Einsatzort
angeordnet sind,
wobei der Ultraschallwandler (20) ein Piezoelement (24) mit einer ersten und einer zweiten metallischen Beschichtung (21, 22) als Elektroden aufweist, wobei die erste metallische Beschichtung (21) mindestens an einer der Leiterplatte (10) zugewandten Seite des Piezoelements (24) ausgebildet ist und wobei sich die zweite metallische Beschichtung (22) von einer der Leiterplatte (10) abgewandten Seite des Piezoelements (24) durchgängig bis zu der der Leiterplatte (10) zugewandten Seite erstreckt,
**dadurch gekennzeichnet,**
**dass** die erste und die zweite metallische Beschichtung (21, 22) flächig mit auf der Leiterplatte (10) vorhandenen elektrischen Kontakten (15, 16) verbunden sind und
**dass** der Ultraschallwandler (20) flächig auf der Leiterplatte (10) aufliegend montiert ist.

2. Ultraschallbaugruppe nach Anspruch 1,
**dadurch gekennzeichnet,**
**dass** der Ultraschallwandler (20) mit einem elektrisch leitfähigen Kleber (50) auf die Leiterplatte (10) geklebt und so mit den elektrischen Kontakten (15, 16) der Leiterplatte (10) verbunden ist.

3. Ultraschallbaugruppe nach Anspruch 1 oder 2,
**dadurch gekennzeichnet,**
**dass** der Ultraschallwandler (20) auf die Leiterplatte (10) gelötet und so mit den elektrischen Kontakten (15, 16) der Leiterplatte (10) verbunden ist.

4. Ultraschallbaugruppe nach Anspruch 2 oder 3,
**dadurch gekennzeichnet,**
**dass** in der Leiterplatte (10) eine Nut (18) geformt ist und
**dass** die Lötverbindung (50) und/oder der elektrisch leitfähige Kleber (50) beidseitig der Nut (18) vorgesehen ist.

5. Ultraschallbaugruppe nach Anspruch 4,
**dadurch gekennzeichnet,**
**dass** die Nut (18) als Durchbruch (18) ausgebildet ist,
**dass** durch die erste und zweite metallische Beschichtung (21, 22) auf der der Leiterplatte (10) zugewandten Seite des Piezoelements (24) eine Lücke (23) ohne metallische Beschichtung gebildet ist und
**dass** das Piezoelement (24) so ausgerichtet ist, dass die Lücke (23) mit dem Durchbruch (18) fluchtet.

6. Ultraschallbaugruppe nach einem der Ansprüche 1 bis 5,
**dadurch gekennzeichnet,**
**dass** der Ultraschallwandler (20) ungedämpft gelagert ist.

7. Ultraschallbaugruppe nach einem der Ansprüche 1 bis 6,
**dadurch gekennzeichnet,**
**dass** der Ultraschallwandler (20) zum ungedämpften Schwingen schaumlos gelagert ist.

8. Ultraschallbaugruppe nach einem der Ansprüche 1 bis 7,
**dadurch gekennzeichnet,**
**dass** der Ultraschallwandler (20) eine Auskoppelschicht (28) zum gerichteten Aussenden von Ultraschallwellen aufweist.

9. Ultraschallbaugruppe nach einem der Ansprüche 1 bis 8,
**dadurch gekennzeichnet,**
**dass** zum Reduzieren von Schwingungsausbreitungen auf der Leiterplatte (10) die erste metallische Beschichtung (21) des Ultraschallwandlers an mehreren voneinander beabstandeten Kontaktstellen (15a, 15b, 15c) mit der Leiterplatte (10) verbunden ist.

10. Ultraschall-Sensorsystem,
**dadurch gekennzeichnet,**
**dass** eine erste Ultraschallbaugruppe nach einem der Ansprüche 1 bis 9 und eine zweite Ultraschallbaugruppe nach einem der Ansprüche 1 bis 9 vorhanden sind,
wobei die erste Ultraschallbaugruppe als Ultraschallsender und die zweite Ultraschallbaugruppe als Ultraschallempfänger gebildet ist, und
wobei zum Bilden eines Überwachungsbereichs der Ultraschallsender und der Ultraschallempfänger aufeinander ausgerichtet sind.

11. Ultraschall-Sensorsystem nach Anspruch 10,
**dadurch gekennzeichnet,**
**dass** die erste und die zweite Ultraschallbaugruppe über eine gabelartige Verbindung miteinander verbunden sind,
**dass** Mittel zur Schwingungsentkopplung zwischen der ersten und der zweiten Ultraschallbaugruppe vorhanden sind, und
**dass** ein gemeinsames Befestigungsmittel (40) zum Anbringen des Ultraschall-Sensorsystems an einem Einsatzort vorhanden ist.

12. Ultraschall-Sensorsystem nach Anspruch 11,
**dadurch gekennzeichnet,**
**dass** die Mittel zur Schwingungsentkopplung durch einen flexiblen Abschnitt gebildet sind, insbesondere durch einen flexiblen Bereich der Leiterplatte (10)
der ersten Ultraschallbaugruppe oder der Leiterplatte (10) der zweiten Ultraschallbaugruppe.
